# EUROPEAN PATENT SPECIFICATION

(11) **EP 4 274 019 B1**
(45) Date of publication and mention of the grant of the patent: **07.10.2026**
(21) Application number: 21913109.1
(22) Date of filing: 12.08.2021
(51) Int. Cl.: H01P 3/02, H01Q 5/321, H01P 1/203, H01Q 9/28, H01Q 21/26, H10W 20/40

(54) **COUPLING STRUCTURE, RESONANT STRUCTURE, LOW-FREQUENCY RADIATION UNIT, ANTENNA AND ELECTROMAGNETIC BOUNDARY**
KOPPLUNGSSTRUKTUR, RESONANZSTRUKTUR, NIEDERFREQUENZSTRAHLUNGSEINHEIT, ANTENNE UND ELEKTROMAGNETISCHE GRENZE
STRUCTURE DE COUPLAGE, STRUCTURE RÉSONANTE, UNITÉ DE RAYONNEMENT BASSE FRÉQUENCE, ANTENNE ET LIMITE ÉLECTROMAGNÉTIQUE

(30) Priority: 31.12.2020 CN 202011642461
(43) Date of publication of application: 08.11.2023
(73) Proprietor: Comba Telecom Technology (Guangzhou) Limited, Guangzhou, Guangdong 510730 (CN); Comba RF Technology (Guangzhou) Ltd, Guangzhou, Guangdong 510555 (CN)
(72) Inventor: LAI, Zhanjun, Guangzhou, Guangdong 510730 (CN); ZHENG, Zhilun, Guangzhou, Guangdong 510730 (CN); LI, Mingchao, Guangzhou, Guangdong 510730 (CN); SU, Guosheng, Guangzhou, Guangdong 510730 (CN); LIANG, Jiaju, Guangzhou, Guangdong 510730 (CN); LIU, Peitao, Guangzhou, Guangdong 510730 (CN); WANG, Qiang, Guangzhou, Guangdong 510730 (CN)
(74) Representative: Gulde & Partner
(86) International application number: PCT/CN2021/112250
(87) International publication number: WO 2022/142361

(56) References cited:
- EP-A1- 0 933 831
- WO-A1-2014/088635
- CN-A- 107 735 903
- CN-A- 112 787 061
- CN-U- 201 466 197
- CN-U- 213 989 160
- US-A1- 2003 030 589
- US-A1- 2005 270 243
- US-A1- 2007 296 013
- US-A1- 2008 048 797
- WANG YONGQIANG, MA KAIXUE, MOU SHOUXIAN: "A Compact SISL Balun Using Compensated Interdigital Capacitor", IEEE MICROWAVE AND WIRELESS COMPONENTS LETTERS, IEEE SERVICE CENTER, NEW YORK, NY., US, vol. 27, no. 9, 1 September 2017 (2017-09-01), US , pages 797 - 799, XP055948411, ISSN: 1531-1309, DOI: 10.1109/LMWC.2017.2734747
- STEPINSKI TADEUSZ; MAńKA MICHAł; MARTOWICZ ADAM; RATHOD VIVEK T.: "Interdigital transducers in structural health monitoring based on Lamb waves: a state of the art", PROCEEDINGS OF SPIE, SPIE, US, vol. 9803, 20 April 2016 (2016-04-20), US , pages 98030N - 98030N-15, XP060068905, ISBN: 978-1-5106-1533-5, DOI: 10.1117/12.2222144

## Description

### TECHNICAL FIELD

The present disclosure relates to the technical field of mobile communications and, in particular, to a coupling structure and a resonant structure, radiation unit, low frequency antenna and electromagnetic boundary to which the coupling structure is applied.

### BACKGROUND

With the development of mobile communication systems, products and components for communication systems such as base station antennas and filters, combiners and duplexers have also developed rapidly. Coupling structures are often used in the feed structure of antenna radiation units, radiation arms, electromagnetic boundaries, and transmission lines with filtering characteristics.

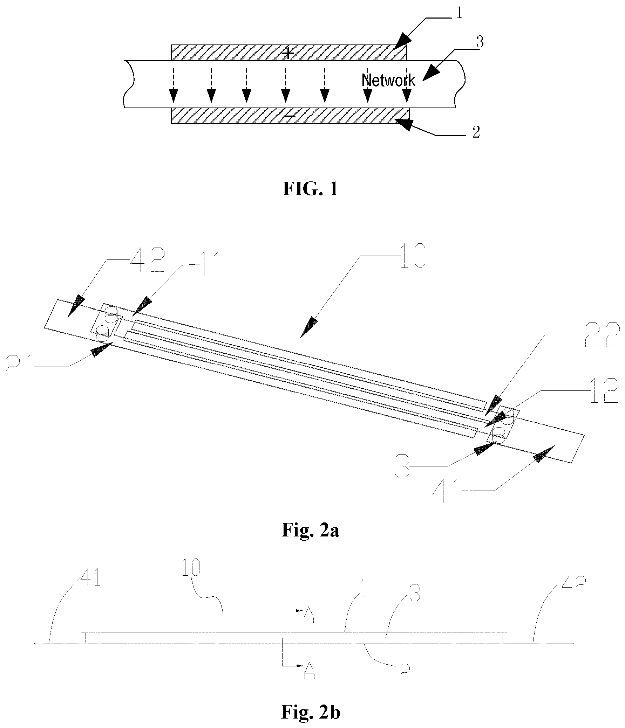

It is well known that the coupling amount in a coupling structure (generally referred to as capacitance in the case of capacitive coupling structures) is proportional to the amount of charge and is also related to the overlapping area of the polar plates with an electrical potential difference. Referring to Fig. 1, which shows the schematic diagram of a conventional coupling structure, it can be seen that the electric field in the coupling structure is directed from the conductor with a high electrical potential (positive charge) to the conductor with a low electrical potential (negative charge) and that the charge is mainly concentrated on a lower surface of the upper conductor and the upper surface of the lower conductor. Thus, in order to achieve large coupling amounts, wider microstrip lines or metal layers are used to form the coupling structure wherever possible, or multi-layer metal-to-metal coupling is used to achieve the required coupling amount.

However, when the coupling structure is used in an antenna, for example in a radiation unit as a radiation arm, the coupling structure formed by the wide microstrip lines (or metal layers) has a large area, and while providing sufficient coupling amount, it tends to generate strong induced currents when other radiation units placed by the neighbor are in operation, thus affecting the performance index of other radiation units placed by the neighbor.

The use of multi-layer PCBs to produce coupling devices to achieve the required large coupling amount is a more complex and costly process.

Prior art reference 1 (US2007/296013A1) discloses one approach to reduce the required chip area involves stacking several layers of conductive plates, which are alternately connected to form opposite electrodes of the capacitor. Another approach to reduce the required chip area involves the use of a layer of parallel interdigitated strips as electrodes having a dielectric material therebetween.

Prior art reference 2 (US2008/048797A1) discloses a high frequency component with a substrate constructed of a plurality of dielectric layers and, between them, electrode layers having conducting track structures, in which substrate at least one capacitive element and at least one inductive element is formed.

Prior art reference 3 (WO2014/088635A1) discloses a folded meta-inspired antenna includes first and second conductive layers disposed on opposite sides of a substrate to provide a wideband distributed structure.

Prior art reference 4 (US2003/030589A1) discloses an antenna being capable of receiving and transmitting radiobroadcast messages at least two frequencies of high and low value, in which a first and second radiating elements being connected to each other by a resonant circuit.

Prior art reference 5 (US 2005/270243 A1) discloses an antenna operative in a plurality of frequency bands. The antenna comprises first and second high band resonators, a resonating meanderline and a counterpoise. One or more of the first resonating element, the second resonating element and the resonating meanderline are coupled by magnetic and/or capacitive coupling to provide operation in the plurality of frequency bands.

The abovementioned prior art references disclose the technical solution similar to the current invention but are different basically.

### SUMMARY

It is a primary object of the present disclosure to provide a coupling structure that is simple in structure and can facilitate a reduction in size based on the provision of the required coupling amount.

It is a further object of the present disclosure to provide a resonant structure employing the above coupling structure.

It is a further object of the present disclosure to provide a low frequency radiation unit employing the above resonant structure.

It is a further object of the present disclosure to provide an antenna employing the above radiation unit.

It is a further object of the present disclosure to provide an electromagnetic boundary employing the above resonant structure.

In order to achieve the above objects, the present disclosure provides the following technical solutions:

In a first aspect, there is provided a frequency radiation unit as defined by the appended set of claims.

Optionally, the conductor strips of each layer of conductors operate at both a high electrical potential and low electrical potential, the high electrical potential and low electrical potential are relative electrical potentials, with part of the conductor strips operating at the high electrical potential and the other part of the conductor strips having a coupling relationship with them operating at the low electrical potential.

Optionally, the conductor strip operating at the high electrical potential is connected to one conductor section, and the conductor strip operating at the low electrical potential is connected to another conductor section.

Further, the coupling structure further includes a dielectric plate, each layer of the conductor being laminated in a thickness direction of the dielectric plate, the two conductor sections being provided on a surface of the dielectric plate, the conductor sections being integrally formed with a conductor strip located on the same layer thereof and operating at the same electrical potential, the conductor strip located on two different layers thereof being electrically connected to the conductor sections via a plated through hole.

Optionally, two of the conductor sections are disposed at two ends of the conductor strip.

Optionally, there is an electrical potential difference between every two adjacent conductor strips operating at different electrical potentials respectively in the plurality of conductor strips of the same layer.

Optionally, in the conductor strips of the same layer, at least two conductor strips operating at one electrical potential are provided between two conductor strips operating at another electrical potential.

Optionally, the number of conductor strips operating at a high electrical potential is the same as or different from the number of conductor strips operating at a low electrical potential.

Optionally, along a lamination direction of the layers of conductor strips, the sum of the projected areas of the conductor strips is greater than the sum of the projected areas of the gaps between the conductor strips.

Optionally, for a same layer of conductors, the sum of widths of the conductor strips is greater than the sum of widths of the gaps between the conductor strips.

As a second aspect, the present disclosure relates to a resonant structure including a capacitor and an inductor, the capacitor being connected in series or in parallel with the inductor, wherein the capacitor is composed of the above coupling structures.

Optionally, the inductor includes a folded-type conductor or a wraparound-type conductor provided on a dielectric plate (3).

As a third aspect, the present disclosure relates to a low frequency radiation unit including a radiation arm, the radiation arm including a resonant structure as described above.

Optionally, the radiation arm is a ring-shaped radiation arm formed by jointing a plurality of the resonance structures.

As a fourth aspect, the present disclosure relates to an antenna as defined by the appended set of claims.

Further, the antenna further includes a high frequency radiation unit, the high frequency radiation unit being provided between the two adjacent low frequency radiation units, and/or, the high frequency radiation unit being provided between the two adjacent radiation arms of the low frequency radiation unit.

Further, the antenna further includes an electromagnetic boundary, the electromagnetic boundary being provided around the low frequency radiation unit.

Optionally, the electromagnetic boundary is composed by jointing a plurality of the resonant structures.

As a fourth aspect, the present disclosure relates to an electromagnetic boundary for being provided between the radiation units to avoid interference between the radiation units, the electromagnetic boundary including the resonant structures.

The technical solution provided by the present disclosure brings the following beneficial effect:
1. In the coupling structure of the present disclosure, by separating a plurality of conductor strips on each layer of the conductor having a coupling relationship between the two layers, and by making the conductor strips operate with an electrical potential difference from the conductor strips located in the same layer and adjacent to each other, the electric field direction can have two paths from the conductor strip with a high electrical potential to the conductor strip with a low electrical potential in the same layer and from the conductor strip with a high electrical potential to the conductor strip with a low electrical potential in another layer, the conductor strips carry more charges, this allows a larger coupling amount to be achieved, i.e. the coupling structure of the present disclosure has a smaller size when the same coupling amount is achieved.
2. In the coupling structure of the present disclosure, conductor strips operating at the same electrical potential are connected to one conductor section, and conductor strips operating at another electrical potential are connected to another conductor section, and this is shown by the fact that the conductor strips located on the same layer are integrally formed and the conductor strips located on two different layers from the conductor section are connected to the conductor section via a plated through hole, so that only two conductor sections are required to apply the voltage to all the conductor strips to form a coupling relationship. The structure is relatively simple.
3. The resonant structure of the present disclosure has the advantage of a coupling structure due to the use of the coupling structure described above. In its disclosure to the radiation arm of the radiation unit, the resonant structure can be used to achieve a lower resonant frequency when the radiation arm size and the dielectric material are the same.
4. In the radiation unit of the present disclosure, since the above resonant structure is applied, the size of the radiation arm is smaller when the same resonant frequency is achieved, which facilitates the miniaturization of the antenna.
5. In the antenna of the present disclosure, the antenna size is smaller and the radiation performance is better since the above radiation unit is applied.
6. In the electromagnetic boundary of the present disclosure, since the above resonant structure is applied, it has bandpass characteristics in the low frequency band and high resistance characteristics in the high frequency band, which can be applied to the dual frequency antenna to improve the performance of the low frequency oscillator, while weakening the impact on the high frequency oscillator.

### BRIEF DESCRIPTION OF THE DRAWINGS

In order to explain the technical solutions in the embodiments of the present disclosure more clearly, the drawings to be used in the description of the embodiments of the present disclosure will be briefly illustrated below.
Fig. 1 shows an electromagnetic schematic diagram of a conventional coupling structure;
Fig. 2a shows a schematic diagram of the structure of the coupling structure provided in one embodiment of the present disclosure;
Fig. 2b shows a schematic diagram of the structure of the coupling structure provided in another embodiment of the present disclosure;
Fig. 3 shows an A-A oriented cross-sectional view of the coupling structure shown in Fig. 2b, illustrating the pointing of the electric field during operation of the coupling structure;
Fig. 4 shows an equivalent circuit diagram of the coupling structure shown in Fig. 2b;
Fig. 5 shows a simulation of the coupling structure of the present disclosure with the two-port S₂₁ parameters of the conventional coupling structure;
Fig. 6 shows a simulation of the coupling structure of the present disclosure with the single port S₁₁ parameters of the conventional coupling structure;
Fig. 7 shows a structural schematic of the coupling structure of another embodiment of the present disclosure, illustrating a plurality of conductor strips of a single layer of conductors and their interrelationships;
Fig. 8 shows a structural schematic of the coupling structure of another embodiment of the present disclosure, illustrating a plurality of conductor strips of a single layer of conductors and their interrelationships;
Fig. 9 is a schematic diagram of the structure of the resonant structure of one embodiment of the present disclosure being applied to a linear oscillator;
Fig. 10 is a schematic diagram of the structure of the resonant structure of another embodiment of the present disclosure being applied to a linear oscillators;
Fig. 11 shows a structural comparison diagram of three linear oscillators;
Fig. 12 is a simulation diagram of the return loss of the three linear oscillators shown in Fig. 11;
Fig. 13 is a three-dimensional diagram of a low frequency radiation unit of one embodiment of the present disclosure;
Fig. 14 is a schematic diagram of the radiation surface of a low frequency radiation unit of another embodiment of the present disclosure;
Fig. 15 is a three-dimensional diagram of the low frequency radiation unit shown in Fig. 14;
Fig. 16 shows a schematic diagram of the structure of the electromagnetic boundary of one embodiment of the present disclosure;
Fig.17 shows a schematic diagram of the structure of the electromagnetic boundary of another embodiment of the present disclosure;
Fig. 18 shows an equivalent circuit diagram of the electromagnetic boundary of the present disclosure;
Fig. 19 shows a frequency response graph of the electromagnetic boundary of the present disclosure; and
Fig. 20 shows a schematic diagram of the structure of an antenna of an embodiment of the present disclosure.

### DETAILED DESCRIPTION

Embodiments of the present disclosure will be described in more detail below with reference to the accompanying drawings. Although certain embodiments of the present disclosure are shown in the accompanying drawings, it should be understood, however, that the present disclosure may be implemented in various forms and should not be construed as being limited to the embodiments set forth herein, but rather are provided for a more thorough and complete understanding of the present disclosure. It should be understood that the accompanying drawings and embodiments of the present disclosure are intended to be exemplary only and are not intended to limit the scope of protection of the present disclosure.

It should be understood that the individual steps documented in the method embodiments of the present disclosure may be performed in a different order, and/or in parallel. Furthermore, the method embodiments may include additional steps and/or omit the execution of the steps illustrated. The scope of the present disclosure is not limited in this respect.

As used herein, the term "including" and variations thereof are open-ended, i.e., "including but not limited to". The term "connection" may be a direct connection or an indirect connection via an intermediate component (element). The term "an embodiment" means "at least one embodiment"; the term "another embodiment" means "at least one additional embodiment"; the term "another embodiment" means "at least one another embodiment", the term "some embodiments" indicates "at least some embodiments". Relative definitions of other terms will be given in the description below.

It is to be noted that the concepts "first", "second", etc., referred to in the present disclosure are used only to distinguish devices, modules or units and are not intended to define them as necessarily different devices, modules or units, nor are they intended to define the order or interdependence of the functions performed by these devices, modules or units.

Referring to Figs. 2 to 8, as a first aspect, the present disclosure relates to a coupling structure 10, which mainly reflects capacitive coupling characteristics and can be used as a capacitor alone or connected with an inductive element to form an LC resonant structure, suitable for use in the feed structure of base station antennas, the radiation arm of radiation units and electromagnetic boundaries, for reducing the size of the coupling structure on the premise of providing the required coupling amount, which in turn facilitates the miniaturization design of the antenna. In addition, the coupling structure mainly reflects the capacitive characteristics when used in the LC resonant structure, which allows the resonant structure to have a relatively lower resonant frequency, a low frequency bandpass, and a high frequency band resistance characteristic, which enhances the radiation performance of the multi-frequency antenna.

The coupling structure 10 includes at least two layers of conductors, the two adjacent layers of conductors are arranged in a cascading manner, so that when the voltage is applied to the adjacent two layers of conductors, the two layers of conductors have an electrical potential difference between the two layers of conductors and form a capacitance, that is, there is a capacitive coupling relationship.

The at least two layers of conductors may be supported by a dielectric plate 3, when the conductors are provided with two layers, the two layers of conductors are provided on the front and back sides of the dielectric plate; when the conductors are provided with three or more layers, the dielectric plate is a multilayer dielectric plate, the multilayer conductors are stacked in layers along the thickness direction of the dielectric plate, two of the layers of conductors are provided on the two outermost surfaces of the dielectric plate.

The conductors may also be supported by means of a dielectric support in point contact with the conductors, with the conductors on the upper layer being disposed in suspension with respect to the conductor on the lower layer.

The conductors are thus arranged in layers so that a coupling gap is formed between the two different layers of conductors and a coupling relationship can be formed between the two different layers of conductors when a voltage is applied.

The following is an example of the coupling structure 10 with two layers of conductors 1 and 2 to illustrate the specific structure and working principle of the coupling structure of the present disclosure.

The coupling structure includes two layers of conductors 1, 2 and a dielectric plate 3, the two layers of conductors 1, 2 being disposed on the front and the back side of the dielectric plate 3. Each layer of conductors includes a plurality of conductor strips, the plurality of conductor strips being arranged side by side and having a gap between them; between the conductor strips of two adjacent layers of conductors, the mutual projection of the upper conductor strip and the lower conductor strip at least partially overlaps.

In one specific embodiment, the plurality of conductor strips of each layer of conductors operate at high and low electrical potentials, with high and low electrical potentials being electrical potentials with an electrical potential differences, and when a voltage is applied to the conductor strips, i.e. when the conductor strips operate, a part of the conductor strips are at a high electrical potential and the other part of the conductor strips are at a low electrical potential, so that an electric field from the high electrical potential to the low electrical potential can be formed, i.e. a coupling relationship is formed between the conductor strips of the same layer.

Between two adjacent layers of conductor strips, a plurality of conductor strips in the upper layer and a plurality of conductor strips in the lower layer are disposed opposite to each other and their projections coincide with each other, and a conductor strip in the upper layer is opposite in electrical potential to a corresponding conductor strip in the lower layer, so that an electric field in which the electrical potential pointed from the high electrical potential to the low electrical potential is formed between every two corresponding conductor strips of the two different layers.

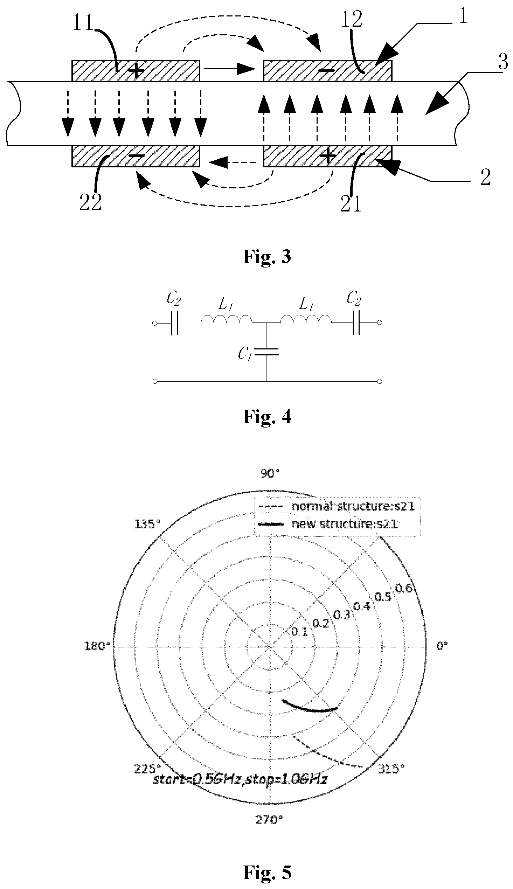

Combining with Fig. 3, in Fig. 3, the high electrical potential is indicated by the "+" sign and the low electrical potential is indicated by the "-" sign. In this embodiment, the coupling structure has four conductor strips, each layer has two conductor strips. Conductor strip 11 and conductor strip 12 are located on the front side of the dielectric plate 3, conductor strip 21 and conductor strip 22 are located on the back side of the dielectric plate 3, and the two conductor strips on the same side are separated by a gap.

In the two conductor strips of the same layer, for the conductor strip 11 and the conductor strip 12 on the front side of the dielectric plate 3, the conductor strip 11 is positively charged and has a high electrical potential, and the conductor strip 12 is negatively charged and has a low electrical potential; for the conductor strip 21 and the conductor strip 22 on the back side of the dielectric plate, the conductor strip 21 is positively charged and has a high electrical potential, and the conductor strip 22 is negatively charged and has a low electrical potential, so that the two conductor strips of the same layer have opposite electrical potentials due to the different charges they carry and have an electrical potential difference, thus an electric field in which the high electrical potential conductor strip is pointed to the low electrical potential conductor strip is formed.

Between the two conductor strips of different layers, conductor strip 11 and conductor strip 22 are facing each other and have opposite electrical potentials, and conductor strip 12 and conductor strip 21 are facing each other and have opposite electrical potentials, thus an electric field in which the high electrical potential conductor strip is pointed to the low electrical potential conductor strip is formed between the two different layers of conductor strips.

As can be seen from the figures, the path of the electric field from the high electrical potential conductor strips to the low electrical potential conductor strips in the above example coupling structure includes a path located inside the dielectric plate and a path located on the surface of the dielectric plate, allowing both the front and the back side of the conductor strip to carry charge, which can carry more charge and thus have a greater coupling capacitance compared to the conventional coupling structure.

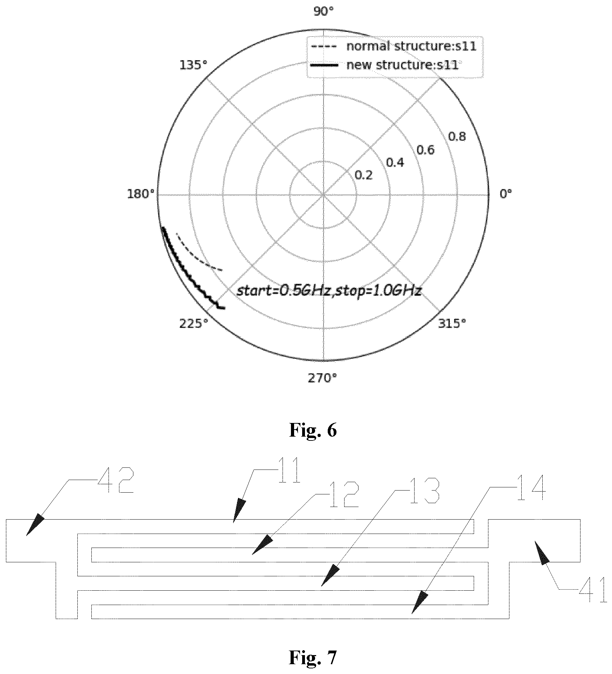

Fig. 4 shows an equivalent circuit diagram of the coupling structure provided in the present disclosure, illustrating the coupling amount of the above coupling structure with both capacitance C1 and C2, increasing the coupling amount of C2 relative to the conventional coupling structure. In order to compare the size of the coupling amount of the coupling structure of the present disclosure with that of the conventional coupling structure, the above coupling structure and the conventional coupling structure with the same projection dimensions (same 20cm²) are used and simulated for the two-port S₂₁ parameter and the single-port S₁₁ parameter, forming the simulation diagrams for the two-port S₂₁ parameter and the single-port S₁₁ parameter of the coupling structure shown in Fig. 5 and Fig. 6, in addition; according to the corresponding equivalent circuit, the parameter values shown in Table 1 can be calculated.

**Table 1 Parameter value of the equivalent circuit**

| | Inductance L₁ (nH) | capacitance C₁ (pF) | capacitance C₂ (pF) |
|---|---|---|---|
| Conventional surface coupling structure | 0.63 | 14.5 | / |
| Two-layer cross-coupling structure of the present disclosure | 1.1 | 25.3 | 23.2 |
| Note: The equivalent values of inductance and capacitance in this table apply to equivalent circuits up to 1 GHz | | | |

As can be seen from the parameter values of the equivalent circuit, with the same projection dimensions, the coupling amount of the conventional surface coupling structure has only capacitance C1, while the coupling amount of the coupling structure of the present disclosure has capacitance C1 and capacitance C2. The coupling structure of the present disclosure has a higher capacitance than the conventional coupling structure and has a better coupling effect, this characteristic helps to improve the conduction characteristics of the coupling structure in high frequency applications. This characteristic can also be equivalently described as: the new coupling structure can have a smaller size if the design requires the same value of capacitance, this characteristic facilitates the miniaturization of the device.

When a larger coupling amount is required, this can be achieved by having more conductor strips on each layer. Referring to Fig. 7, this embodiment is an extension of the above embodiment, where each layer of conductors has four conductor strips, for example four conductor strips of one layer of conductors, where two conductor strips 11, 13 operate at the high electrical potential and the other two conductor strips 12, 14 operate at the low electrical potential, and where the four conductor strips are arranged in an alternating manner with an electrical potential difference so that a coupling relationship is formed between every two adjacent conductor strips of the same layer. A greater amount of coupling can be achieved.

In addition, the number of conductor strips operating at the two electrical potentials may be equal or unequal, in one embodiment, there are more conductor strips operating at one electrical potential than the conductor strips operating at the other electrical potential to achieve a specific coupling amount.

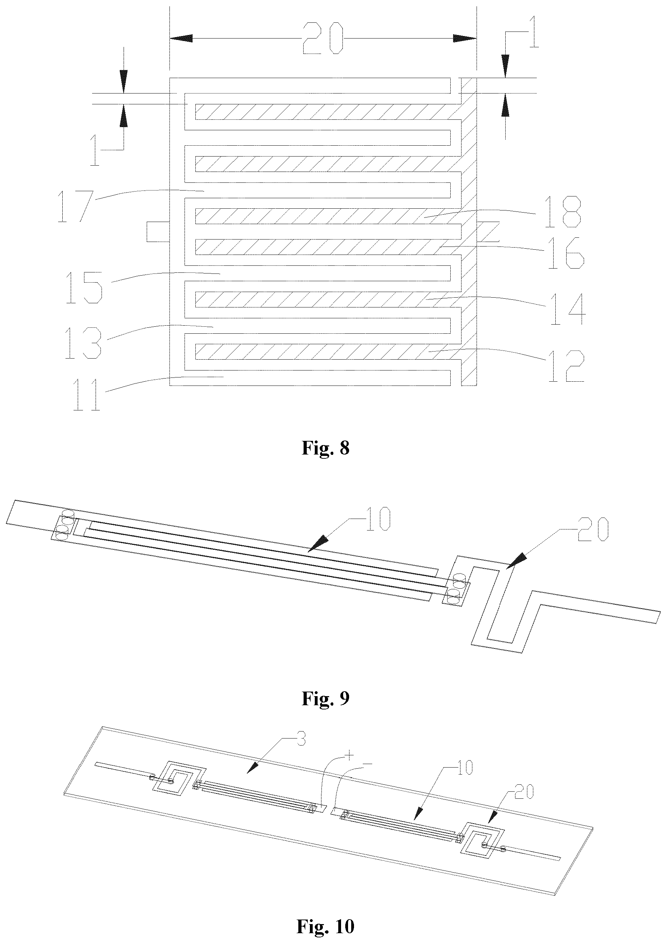

Combining with Fig. 8, the conductor strips 12, 14, 16 and 18 shown in the shadow of the figure operate at one electrical potential and the conductor strips 11, 13, 15 and 17 shown in blank operate at another electrical potential. As can be seen from the figure, two adjacent conductor strips 15, 17 operating at the same electrical potential can be provided with two conductor strips 16, 18 operating at another electrical potential between them. A pointing electric field is formed between the conductor strip operating at one electrical potential and an adjacent conductor strip with an opposite electrical potential (i.e., there is a potential difference), and the conductor strips are with a coupling relationship.

In addition, a plurality of conductor strips in the same layer can be subjected to a plurality of voltages so that the electrical potential between the plurality of conductor strips increases in one direction and forms a gradual electric field, thus allowing a coupling relationship to be formed between two adjacent conductor strips and increasing the coupling amount.

In addition, the projections of the corresponding conductor strips of the upper and lower layer may not overlap completely with each other, and the projections between the conductor strips with an electrical potential difference overlap at least partially, which also enables the coupling function.

In summary, in the coupling structure, there is an electrical potential difference between at least one conductor strip and the adjacent conductor strip when operating with an applied voltage, thereby generating an electric field from the conductor strip with a high electrical potential to the conductor strip with a low electrical potential, resulting in a capacitive coupling relationship. Between two different layers of conductor strips, there is an electrical potential difference between at least one of the conductor strips of one layer during operation and at least one of the conductor strips located in the other layer, and there is an overlap area in the projection of each other, which also forms an electric field from the conductor strip with a high electrical potential to the conductor strip with a low electrical potential, forming a capacitive coupling relationship.

Therefore, the coupling structure described in the present disclosure forms an electric field from the higher electrical potential to the lower electrical potential between conductor strips of two different layers, as well as an electric field from the higher electrical potential to the lower electrical potential between neighboring conductor strips of the same layer. Compared to conventional surface coupling structures, the coupling structure of the present disclosure is strip coupling, has more coupling paths, and achieves a larger coupling amount, in other words, when the same coupling amount is achieved, the coupling structure of the present disclosure has a smaller size.

Combining with Fig. 2a, Fig. 2b and Fig. 7, optionally, the coupling structure further includes two conductor sections 4 for connecting to an external transmission line to access the voltage of the coupling structure, the conductor sections 4 specifically including a first conductor section 41 and a second conductor section 42, the first conductor section 41 and the second conductor section 42 being provided on one of the surfaces of the dielectric plate 3 and connected to the conductor strip.

In Fig. 2a, the conductor strips 11, 21 operating at the high electrical potential are connected to the second conductor section 42, and the conductor strips 12, 22 operating at the low electrical potential are connected to the first conductor section 41. In Fig. 7, the conductor strips 11, 13 operating at the high electrical potential are connected to the second conductor section 42 and the conductor strips 12, 14 operating at the low electrical potential are connected to the first conductor section 41, the conductor strips being arranged alternately in such a way that they have an electrical potential difference between them. Thus, when a voltage is applied to both conductor sections, the conductor strips connected to the second conductor section 42 are both positively charged and the conductor strips connected to the first conductor section 41 are both negatively charged, and the conductor strips with different charges have an electrical potential difference between them, forming a coupling relationship.

As can be seen from the above, the conductor strips are provided in layers on the dielectric plate and are provided with at least two layers, while the conductor sections are provided on the surface of the dielectric plate (i.e. one layer on the surface of the dielectric plate), in order to achieve the supply of energy from the conductor sections to the conductor strips (i.e. the conductor sections provide the required charge to the conductor strips), wherein the conductor strips located on the same layer as the conductor sections are integrally formed with the conductor sections, while the conductor strips not located on the same layer as the conductor sections are connected to the conductor sections via a plated through hole, whereby the conductor strips can be fed by two conductor sections and each layer of conductor has a conductor strip operating at two different operating electrical potentials, high and low electrical potentials, resulting in a simpler circuit layout for the coupling structure.

Preferably, the first conductor section and the second conductor section are located at two ends of the conductor strip to facilitate circuit design by locating the input and output of the circuit at the two ends of the conductor strip when it is applied to the circuit.

In the above example coupling structure, the capacitive coupling relationship is formed between the two conductor layers, which increases the coupling amount by increasing the pointing path of the electric field, reduces the size compared to a coupling structure with wide microstrip lines when achieving the same coupling amount, and reduces the cost by using only a single layer of the circuit board to achieve the coupling amount target compared to a coupling structure with a multi-layer PCB.

As an extension, the coupling structure has a plurality of layers of conductors, the plurality of layers of conductors being stacked in layers along the thickness direction of the dielectric plate. The setting of conductors of each layer and the relationship between two conductors of different layers are the same as in the above embodiment and will not be repeated here. As a result, a coupling relationship can be formed between the conductor strips of every two adjacent layers of conductors, thus allowing a greater coupling amount to be achieved.

The plurality of conductor strips of each layer of conductors may be cut from planar conductors, wherein adjacent conductors have gaps between them and where the sum of the projected areas of the conductor strips along the direction of the conductor lamination is greater than the sum of the projected areas of the gaps between the conductor strips. Optionally, the sum of the widths of the conductor strips on the same layer of conductors is greater than the sum of the widths of the gaps between the conductor strips, such that the area of the removed conductors is less than the newly-added area in which the charge can be carried, thereby allowing a greater coupling amount to be achieved relative to conventional coupling structures.

Combining with Figs. 9 to 12, as a second aspect, the present disclosure relates to a resonant structure as a practical application of the above coupling structure, which can be applied to an antenna oscillator for radiating a signal. The resonant structure is specifically represented by the above coupling structure 10 connected in series (or in parallel) with the inductor 20 to form an LC series resonant structure (or LC parallel resonant structure), which has the characteristic of conducting at the resonant frequency and presenting a high impedance at off-resonant frequencies, and which, when used in the radiation arm, will give the radiation arm a band-pass filtering characteristic and will also allow the size of the radiation arm to be further reduced.

Referring to Fig. 9, in one embodiment, the inductor is a folded-type inductor, specifically a folded-type conductor with inductive characteristics provided on a dielectric plate, which is connected to one of the conductor sections of the coupling structure to achieve a series connection of the folded-type inductor with the coupling structure.

Referring to Fig. 10, in another embodiment, the inductor is a wraparound-type inductor, specifically a wraparound-type conductor provided on the dielectric plate and having inductive characteristics is connected to one of the conductor sections of the coupling structure to achieve a series connection of the wraparound-type inductor with the coupling structure.

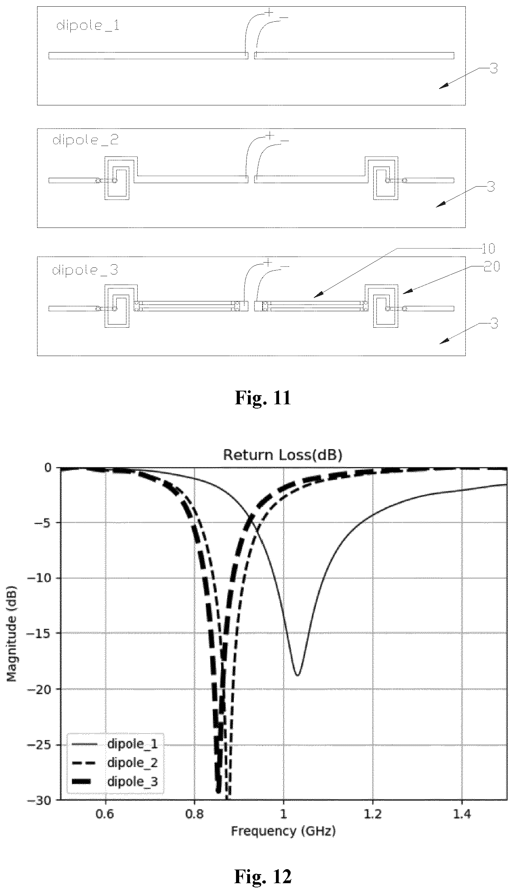

In order to illustrate the characteristics of the coupling structure of the present disclosure to reduce the size of the radiation arm, three linear symmetrical oscillators are compared below, as shown in Fig. 11, setting three calculation models diople_1, dipole_2 and dipole_3 with the same length, where diople_1 is a conventional symmetrical oscillator, dipole_2 is a symmetrical oscillator loaded with a wraparound-type inductor, the dipole_3 is a symmetrical oscillator loaded with the LC series resonant circuit consisting of the coupling structure of the present disclosure and a wraparound-type inductor, and the parameters of the dielectric plate 3 used for the three types of oscillators are limited to the same, and the return loss calculated by the simulation software is shown in Fig. 12. As can be seen from Fig. 12, the symmetrical oscillator using the coupling structure of the present disclosure plus the wraparound-type inductor has the lowest resonant frequency, which also means that the structure of the dipole_3 can have the smallest size if a symmetrical oscillator with the same resonant frequency is designed.

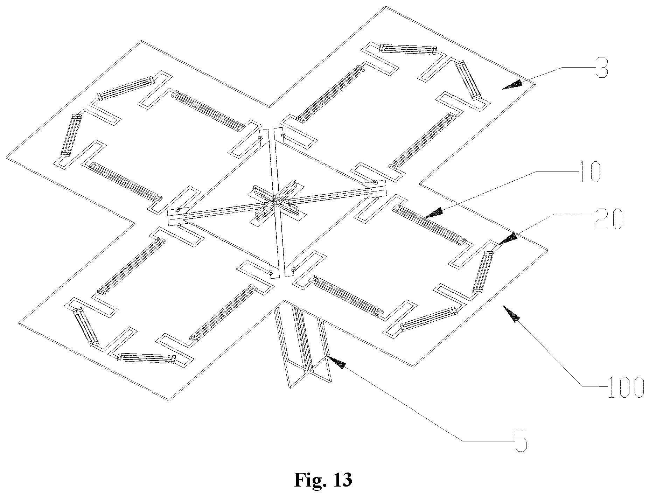

Combining with Figs. 13 to 15, as a third aspect, the present disclosure relates to a low frequency radiation unit including a radiation surface and a feed barron 5 for supporting and feeding the radiation surface, wherein the radiation surface includes four radiation arms arranged as a cross, the radiation arms being preferably annular radiation arms, which are formed by jointing the resonant structure as described above.

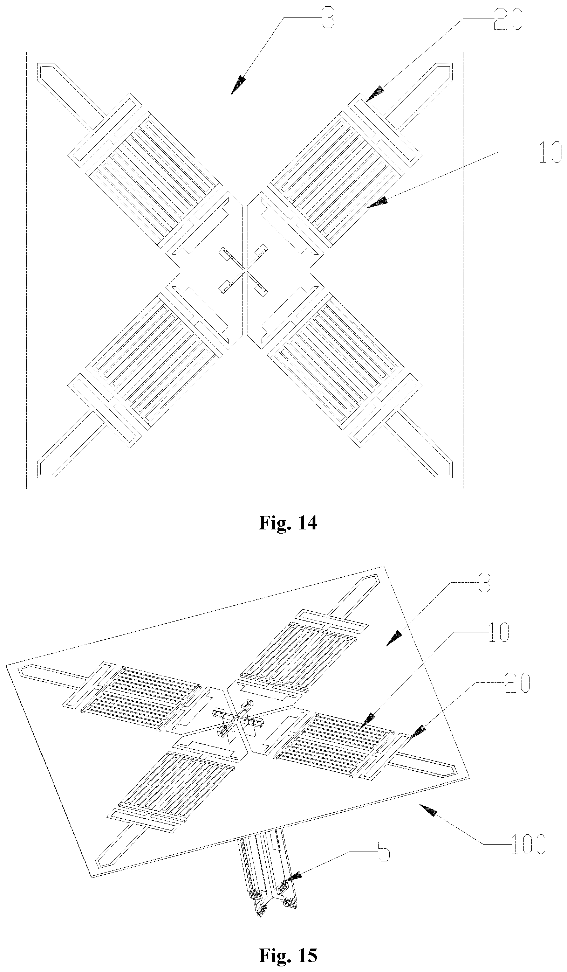

Wherein, in the low frequency radiation unit shown in Fig. 13, the single coupling structure has four conductor strips; in the low frequency radiation unit shown in Fig.15, the single coupling structure has eight conductor strips, allowing for a greater coupling amount relative to a coupling structure with four conductor strips.

By using the above resonant structure as a constituent element of the radiation arm of the low frequency radiation unit, the resonant frequency is lower compared to that of the radiation arm with a conventional resonant structure, thus reducing the size of the radiation arm and facilitating the miniaturization of the antenna.

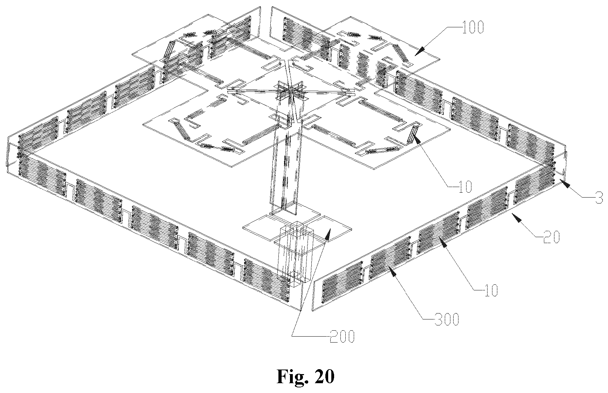

Referring to Fig. 20, as a fourth aspect, the present disclosure also relates to an antenna 1000 including the above low frequency radiation unit 100, a high-frequency radiation unit 200 and an electromagnetic boundary 300, wherein the high-frequency radiation unit is provided between two adjacent low frequency radiation units, and/or the high-frequency radiation unit is provided between two adjacent radiation arms of the low frequency radiation unit, and the electromagnetic boundary 300 is provided around the low frequency radiation unit 100 and configured to reduce the interference between the radiation units and enhance the radiation performance of the antenna.

By using the above resonant structure as a constituent element of the radiation arm of the low frequency radiation unit, the resonant frequency is lower than that of the radiation arm with conventional resonant structure, thus reducing the size of the radiation arm and facilitating the miniaturization of the antenna.

In addition, when the bandpass characteristics of the electromagnetic boundary are configured to be the same as those of the low frequency radiation unit 100, which presents the high resistance characteristics in the frequency band of the high frequency radiation unit, the performance of the low frequency radiation unit can be improved while the effect on the high frequency radiation unit can be attenuated.

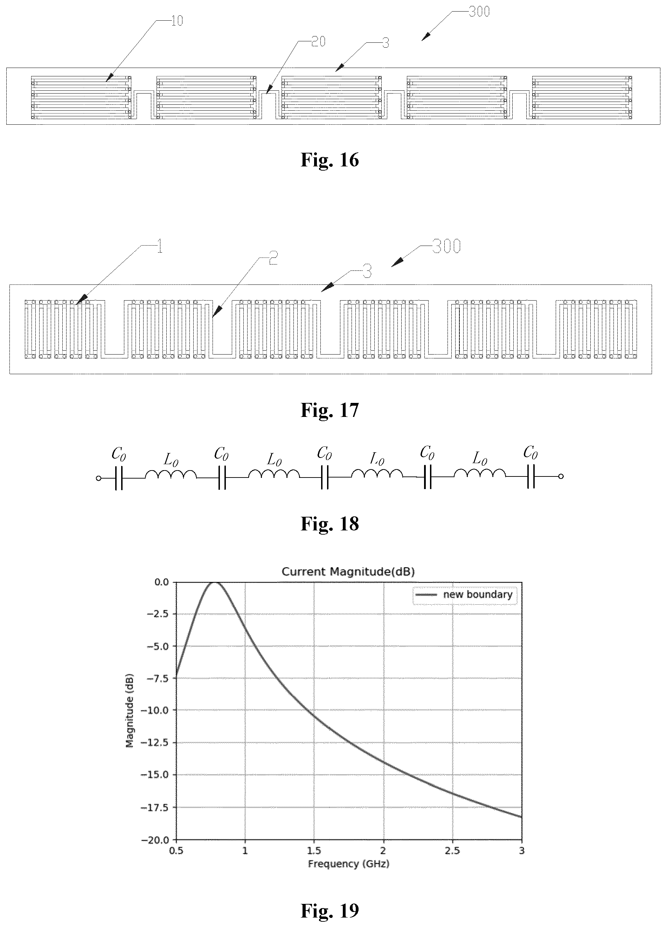

Furthermore, the coupling structures of the present disclosure can also be applied in electromagnetic boundaries, therefore, combining with Figs. 16 to 19, as a fifth aspect, the present disclosure also provides electromagnetic boundaries applying the above resonant structures, which are formed by jointing a plurality of the above resonant structures, for being provided between the radiation units to reduce the interference between the radiation units and to enhance the radiation performance of the antenna.

In the electromagnetic boundary shown in Fig. 16, the coupling structure has a dielectric plate, wherein the length direction of the conductor strip is parallel to the length direction of the dielectric plate; and in the electromagnetic boundary shown in Fig. 17, the coupling structure has a dielectric plate, wherein the length direction of the conductor strip is perpendicular to the length direction of the dielectric plate. In other words, the electromagnetic boundary of the present disclosure allows the extension direction of the conductor strip to be set by the technician according to practical needs in order to use the space of the dielectric plate reasonably and to facilitate the line design.

As the inductance in the equivalent circuit of the coupling structure of the present disclosure is small (much smaller than the inductance value of the folded-type inductor), the practical application mainly presents capacitive characteristics, and the equivalent circuit after connection with the folded-type inductor is shown in Fig. 18. The electromagnetic boundary of the present disclosure can be considered as a cascade of a plurality of resonant structures. The frequency response characteristics of the circuit are shown in Fig. 19. The presented bandpass characteristics of the electromagnetic boundary allow the new electromagnetic boundary to be used in multi-band antennas to improve the radiation unit index of a particular frequency band.

## Claims

1. A low frequency radiation unit (100) comprising a radiation arm, the radiation arm comprises a resonant structure comprising a capacitor and an inductor (20), the capacitor being connected in series or parallel with the inductor (20), the capacitor comprises a coupling structure (10), the coupling structure (10) comprising at least two layers of conductors (1, 2) in a capacitive coupling relationship, each layer of conductors (1, 2) comprises a plurality of conductor strips (11,12,21,22) side by side and having a gap, wherein at least one of the plurality of conductor strips (11,12,21,22) of the same layer has an electrical potential difference from an adjacent conductor strip during operation, and wherein between the conductor strips (11,12,21,22) of two different layers, at least one of the conductor strips (11,12,21,22) of one layer of the two different layers has an electrical potential difference from at least one of the conductor strips (11,12,21,22) of the other layer, and the two different layers at least partially overlap in a direction of a mutual projection with each other, **characterized in that**, the radiation arm is a ring-shaped radiation arm formed by joining a plurality of the resonant structures.

2. The low frequency radiation unit (100) according to claim 1, **characterized in that**, the conductor strips (11,12,21,22) of each layer of conductors (1, 2) operate at two relative electrical potentials, a high electrical potential and a low electrical potential, with part of the conductor strips (11,12,21,22) operating at the high electrical potential and the other part of the conductor strips (11,12,21,22) having a coupling relationship with them operating at the low electrical potential.

3. The low frequency radiation unit (100) according to claim 2, **characterized in that**, the conductor strip operating at the high electrical potential is connected to one conductor section (42), and the conductor strip operating at the low electrical potential is connected to another conductor section (41);
the two conductor sections (41,42) are disposed at the two ends of the conductor strip.

4. The low frequency radiation unit (100) according to claim 3, **characterized in that**, further comprising a dielectric plate, each layer of conductors (1, 2) being laminated in a thickness direction of the dielectric plate, each of the conductor section (41,42) being provided on a surface of the dielectric plate, the conductor section (41,42) being integrally formed with a conductor strip located on the same layer thereof and operating at the same electrical potential, and being electrically connected to a conductor strip located on a different layer thereof and operating at the same electrical potential via a plated through hole.

5. The low frequency radiation unit (100) according to claim 2, **characterized in that**, there is an electrical potential difference between every two adjacent conductor strips (11,12,21,22) operating at different electrical potentials respectively in the plurality of conductor strips (11,12,21,22) of the same layer.

6. The low frequency radiation unit (100) according to claim 2, **characterized in that**, in the conductor strips (11,12,21,22) of the same layer, at least two conductor strips (11,12,21,22) operating at one electrical potential are provided between two conductor strips (11,12,21,22) operating at another electrical potential.

7. The low frequency radiation unit (100) according to claim 2, **characterized in that**, the number of conductor strips (11,12,21,22) operating at a high electrical potential is the same as or different from the number of conductor strips (11,12,21,22) operating at a low electrical potential.

8. The low frequency radiation unit (100) according to claim 1, **characterized in that**, along a lamination direction of the layers of conductor strips (11,12,21,22), the sum of the projected areas of the conductor strips (11,12,21,22) is greater than the sum of the projected areas of the gaps between the conductor strips (11,12,21,22).

9. The low frequency radiation unit (100) according to claim 8, **characterized in that**, for a same layer of conductors, the sum of widths of the conductor strips (11,12,21,22) is greater than the sum of widths of the gaps between the conductor strips (11,12,21,22).

10. The low frequency radiation unit (100) according to claim 1, **characterized in that**, the inductor (20) comprises a folded-type conductor or a wraparound-type conductor provided on a dielectric plate (3).

11. An antenna (1000), comprising a low frequency radiation unit (100), a high frequency radiation unit (200), and an electromagnetic boundary (300) provided around the low frequency radiation unit (100), **characterized in that**,
the high frequency radiation unit (200) being provided between two adjacent low frequency radiation units, and/or, the high frequency radiation unit (200) being provided between two adjacent radiation arms of the low frequency radiation unit (100); and
the low frequency radiation unit (100) is a low frequency radiation unit (100) according to any one of claims 1 to 10, and
the electromagnetic boundary (300) is configured for being provided between radiation units to avoid interference between radiation units, wherein the electromagnetic boundary (300) comprises a plurality of resonant structures being j ointed.

## Patentansprüche

1. Niederfrequenzstrahlungseinheit (100), umfassend einen Strahlungsarm, wobei der Strahlungsarm eine Resonanzstruktur umfasst, umfassend einen Kondensator und einen Induktor (20), wobei der Kondensator mit dem Induktor (20) in Reihe oder parallel geschaltet ist, wobei der Kondensator eine Kopplungsstruktur (10) umfasst, wobei die Kopplungsstruktur (10) mindestens zwei Leiterschichten (1, 2) in einer kapazitiven Kopplungsbeziehung umfasst, wobei jede Leiterschicht (1, 2) mehrere Leiterstreifen (11, 12, 21, 22) umfasst, die nebeneinander angeordnet sind und einen Spalt aufweisen, wobei mindestens einer der mehreren Leiterstreifen (11, 12, 21, 22) derselben Schicht im Betrieb einen elektrischen Potenzialunterschied zu einem benachbarten Leiterstreifen aufweist, und wobei zwischen den Leiterstreifen (11, 12, 21, 22) von zwei verschiedenen Schichten mindestens einer der Leiterstreifen (11, 12, 21, 22) einer Schicht der zwei verschiedenen Schichten einen elektrischen Potenzialunterschied zu mindestens einem der Leiterstreifen (11, 12, 21, 22) der anderen Schicht aufweist, und wobei sich die zwei verschiedenen Schichten in einer Richtung einer gegenseitigen Projektion miteinander zumindest teilweise überlappen, **dadurch gekennzeichnet, dass** der Strahlungsarm ein ringförmiger Strahlungsarm ist, der durch Verbinden mehrerer der Resonanzstrukturen ausgebildet ist.

2. Niederfrequenzstrahlungseinheit (100) nach Anspruch 1, **dadurch gekennzeichnet, dass** die Leiterstreifen (11, 12, 21, 22) jeder Leiterschicht (1, 2) bei zwei relativen elektrischen Potenzialen, einem hohen elektrischen Potenzial und einem niedrigen elektrischen Potenzial, arbeiten, wobei ein Teil der Leiterstreifen (11, 12, 21, 22) bei dem hohen elektrischen Potenzial arbeitet und der andere Teil der Leiterstreifen (11, 12, 21, 22), der eine Kopplungsbeziehung mit dem bei dem hohen elektrischen Potenzial arbeitenden Teil aufweist, bei dem niedrigen elektrischen Potenzial arbeitet.

3. Niederfrequenzstrahlungseinheit (100) nach Anspruch 2, **dadurch gekennzeichnet, dass** der bei dem hohen elektrischen Potenzial arbeitende Leiterstreifen mit einem Leiterabschnitt (42) verbunden ist und der bei dem niedrigen elektrischen Potenzial arbeitende Leiterstreifen mit einem anderen Leiterabschnitt (41) verbunden ist;
und dass die zwei Leiterabschnitte (41, 42) an den zwei Enden des Leiterstreifens angeordnet sind.

4. Niederfrequenzstrahlungseinheit (100) nach Anspruch 3, **dadurch gekennzeichnet, dass** die Niederfrequenzstrahlungseinheit (100) ferner eine dielektrische Platte umfasst, wobei jede Leiterschicht (1, 2) in einer Dickenrichtung der dielektrischen Platte laminiert ist, wobei jeder der Leiterabschnitte (41, 42) an einer Oberfläche der dielektrischen Platte bereitgestellt ist, wobei jeder der Leiterabschnitte (41, 42) mit einem Leiterstreifen, der sich auf derselben Schicht befindet und bei demselben elektrischen Potenzial arbeitet, einstückig ausgebildet ist und mit einem Leiterstreifen, der sich auf einer anderen Schicht befindet und bei demselben elektrischen Potenzial arbeitet, über ein metallisiertes Durchgangsloch elektrisch verbunden ist.

5. Niederfrequenzstrahlungseinheit (100) nach Anspruch 2, **dadurch gekennzeichnet, dass** in den mehreren Leiterstreifen (11, 12, 21, 22) derselben Schicht ein elektrischer Potenzialunterschied zwischen jeweils zwei benachbarten Leiterstreifen (11, 12, 21, 22) vorliegt, die jeweils bei unterschiedlichen elektrischen Potenzialen arbeiten.

6. Niederfrequenzstrahlungseinheit (100) nach Anspruch 2, **dadurch gekennzeichnet, dass** in den Leiterstreifen (11, 12, 21, 22) derselben Schicht mindestens zwei Leiterstreifen (11, 12, 21, 22), die bei einem elektrischen Potenzial arbeiten, zwischen zwei Leiterstreifen (11, 12, 21, 22), die bei einem anderen elektrischen Potenzial arbeiten, angeordnet sind.

7. Niederfrequenzstrahlungseinheit (100) nach Anspruch 2, **dadurch gekennzeichnet, dass** die Anzahl der Leiterstreifen (11, 12, 21, 22), die bei einem hohen elektrischen Potenzial arbeiten, gleich wie oder verschieden von der Anzahl der Leiterstreifen (11, 12, 21, 22) ist, die bei einem niedrigen elektrischen Potenzial arbeiten.

8. Niederfrequenzstrahlungseinheit (100) nach Anspruch 1, **dadurch gekennzeichnet, dass** entlang einer Laminierungsrichtung der Schichten von Leiterstreifen (11, 12, 21, 22) die Summe der projizierten Flächen der Leiterstreifen (11, 12, 21, 22) größer als die Summe der projizierten Flächen der Spalte zwischen den Leiterstreifen (11, 12, 21, 22) ist.

9. Niederfrequenzstrahlungseinheit (100) nach Anspruch 8, **dadurch gekennzeichnet, dass** für eine selbe Leiterschicht die Summe der Breiten der Leiterstreifen (11, 12, 21, 22) größer als die Summe der Breiten der Spalte zwischen den Leiterstreifen (11, 12, 21, 22) ist.

10. Niederfrequenzstrahlungseinheit (100) nach Anspruch 1, **dadurch gekennzeichnet, dass** der Induktor (20) einen gefalteten Leiter oder einen umlaufenden Leiter umfasst, der an einer dielektrischen Platte (3) bereitgestellt ist.

11. Antenne (1000), umfassend eine Niederfrequenzstrahlungseinheit (100), eine Hochfrequenzstrahlungseinheit (200) und eine elektromagnetische Grenze (300), die um die Niederfrequenzstrahlungseinheit (100) herum angeordnet ist, **dadurch gekennzeichnet, dass**
die Hochfrequenzstrahlungseinheit (200) zwischen zwei benachbarten Niederfrequenzstrahlungseinheiten angeordnet ist und/oder die Hochfrequenzstrahlungseinheit (200) zwischen zwei benachbarten Strahlungsarmen der Niederfrequenzstrahlungseinheit (100) angeordnet ist; und
dass die Niederfrequenzstrahlungseinheit (100) eine Niederfrequenzstrahlungseinheit (100) nach einem der Ansprüche 1 bis 10 ist und
die elektromagnetische Grenze (300) dafür eingerichtet ist, zwischen Strahlungseinheiten angeordnet zu werden, um Interferenz zwischen Strahlungseinheiten zu vermeiden, wobei die elektromagnetische Grenze (300) mehrere verbundene Resonanzstrukturen umfasst.

## Revendications

1. Unité de rayonnement basse fréquence (100) comprenant un bras de rayonnement, le bras de rayonnement comprend une structure résonante comprenant un condensateur et une inductance (20), le condensateur étant connecté en série ou en parallèle avec l'inductance (20), le condensateur comprend une structure de couplage (10), la structure de couplage (10) comprenant au moins deux couches de conducteurs (1, 2) dans une relation de couplage capacitif, chaque couche de conducteurs (1, 2) comprend une pluralité de bandes conductrices (11,12, 21,22) côte à côte et ayant un espace, dans laquelle au moins l'une de la pluralité de bandes conductrices (11,12, 21,22) de la même couche présente une différence de potentiel électrique par rapport à une bande conductrice adjacente pendant le fonctionnement, et dans laquelle, entre les bandes conductrices (11,12,21,22) de deux couches différentes, au moins l'une des bandes conductrices (11,12, 21,22) d'une couche des deux couches différentes présente une différence de potentiel électrique par rapport à au moins l'une des bandes conductrices (11,12,21,22) de l'autre couche, et les deux couches différentes se chevauchent au moins partiellement dans une direction de projection mutuelle l'une avec l'autre, **caractérisée en ce que**, le bras de rayonnement est un bras de rayonnement en forme d'anneau formé par assemblage d'une pluralité des structures résonantes.

2. Unité de rayonnement basse fréquence (100) selon la revendication 1, **caractérisée en ce que**, les bandes conductrices (11,12, 21,22) de chaque couche de conducteurs (1,2) fonctionnent à deux potentiels électriques relatifs, un potentiel électrique élevé et un potentiel électrique faible, une partie des bandes conductrices (11,12, 21,22) fonctionnant au potentiel électrique élevé et l'autre partie des bandes conductrices (11,12,21,22) ayant une relation de couplage avec celles-ci fonctionnant au potentiel électrique faible.

3. Unité de rayonnement basse fréquence (100) selon la revendication 2, **caractérisée en ce que**, la bande conductrice fonctionnant au potentiel électrique élevé est connectée à une section conductrice (42), et la bande conductrice fonctionnant au potentiel électrique faible est connectée à une autre section conductrice (41) ;
les deux sections conductrices (41,42) sont disposées aux deux extrémités de la bande conductrice.

4. Unité de rayonnement basse fréquence (100) selon la revendication 3, **caractérisée en ce que**, comprenant en outre une plaque diélectrique, chaque couche de conducteurs (1, 2) étant stratifiée dans une direction d'épaisseur de la plaque diélectrique, chacune de la section conductrice (41,42) étant prévue sur une surface de la plaque diélectrique, la section conductrice (41,42) étant formée d'un seul tenant avec une bande conductrice située sur la même couche que celle-ci et fonctionnant au même potentiel électrique, et étant connectée électriquement à une bande conductrice située sur une couche différente de celle-ci et fonctionnant au même potentiel électrique par l'intermédiaire d'un trou traversant métallisé.

5. Unité de rayonnement basse fréquence (100) selon la revendication 2, **caractérisée en ce que**, il existe une différence de potentiel électrique entre toutes deux bandes conductrices adjacentes (11,12,21,22) fonctionnant respectivement à des potentiels électriques différents dans la pluralité de bandes conductrices (11,12,21,22) de la même couche.

6. Unité de rayonnement basse fréquence (100) selon la revendication 2, **caractérisée en ce que**, dans les bandes conductrices (11,12,21,22) de la même couche, au moins deux bandes conductrices (11,12,21,22) fonctionnant à un potentiel électrique sont prévues entre deux bandes conductrices (11,12,21,22) fonctionnant à un autre potentiel électrique.

7. Unité de rayonnement basse fréquence (100) selon la revendication 2, **caractérisée en ce que**, le nombre de bandes conductrices (11,12,21,22) fonctionnant à un potentiel électrique élevé est identique au nombre de bandes conductrices (11,12,21,22) fonctionnant à un potentiel électrique faible ou différent de celui-ci.

8. Unité de rayonnement basse fréquence (100) selon la revendication 1, **caractérisée en ce que**, le long d'une direction de stratification des couches de bandes conductrices (11,12,21,22), la somme des surfaces projetées des bandes conductrices (11,12,21,22) est supérieure à la somme des surfaces projetées des espaces entre les bandes conductrices (11,12,21,22).

9. Unité de rayonnement basse fréquence (100) selon la revendication 8, **caractérisée en ce que**, pour une même couche de conducteurs, la somme des largeurs des bandes conductrices (11,12,21,22) est supérieure à la somme des largeurs des espaces entre les bandes conductrices (11,12,21,22).

10. Unité de rayonnement basse fréquence (100) selon la revendication 1, **caractérisée en ce que**, l'inductance (20) comprend un conducteur de type replié ou un conducteur de type enveloppant prévu sur une plaque diélectrique (3).

11. Antenne (1000), comprenant une unité de rayonnement basse fréquence (100), une unité de rayonnement haute fréquence (200), et une limite électromagnétique (300) prévue autour de l'unité de rayonnement basse fréquence (100), **caractérisée en ce que**,
l'unité de rayonnement haute fréquence (200) étant prévue entre deux unités de rayonnement basse fréquence adjacentes, et/ou, l'unité de rayonnement haute fréquence (200) étant prévue entre deux bras de rayonnement adjacents de l'unité de rayonnement basse fréquence (100) ; et
l'unité de rayonnement basse fréquence (100) est une unité de rayonnement basse fréquence (100) selon l'une quelconque des revendications 1 à 10, et
la limite électromagnétique (300) est configurée pour être prévue entre des unités de rayonnement afin d'éviter une interférence entre des unités de rayonnement, dans laquelle la limite électromagnétique (300) comprend une pluralité de structures résonantes étant assemblées.
